# EUROPEAN PATENT APPLICATION

(11) **EP 1 942 703 A2**
(43) Date of publication of application: **09.07.2008**
(21) Application number: 08250009.1
(22) Date of filing: 02.01.2008
(51) Int. Cl.: H05B 3/84

(54) **An electrical connector for a window pane of a vehicle**

(30) Priority: 02.01.2007 US 619081
(71) Applicant: AGC AUTOMOTIVE AMERICAS R&D, INC., Ypsilanti MI 48197-9701 (US)
(72) Inventor: Hoepfner, Thimothy P., Grand Ledge , Michigan 48837 (US); Sato, Makoto, Ann Arbor, Michigan 48108 (US)
(74) Representative: Stuttard, Garry Philip

(57) **Abstract**

A window pane (10) has a substrate (14) formed from glass and includes an electrical device (24). The electrical device includes an electrical conductor (16) and an electrical connector (20). A layer (32) of solderable metal is bonded to the connector. A layer of solder is bonded to the layer of solderable metal and the conductor, with the connector and the conductor in electrical communication through the layer of solderable metal and the layer of solder. The substrate has a first coefficient of expansion and the connector has a second coefficient of thermal expansion. A difference between the first and second coefficients of thermal expansion is equal to or less than 5 x 10⁻⁶ /°C for minimizing mechanical stress between the connector and the substrate due to thermal expansion of the connector and the substrate resulting from changes in temperature. The solder is comprised of less than 70 parts by weight of Sn along with a greater than 30 parts by weight of a reaction rate modifier. The reaction rate modifier increases the solderability of the solder to the conductor.

## Description

The subject invention generally relates to a window pane of a vehicle that includes an electrical connector and an electrical conductor. More specifically, the subject invention relates to an electrical connector that transfers electrical energy to an electrical conductor of the window pane, such as a defogger, defroster, antenna, etc.

Electrical connectors are known in the art for use in vehicles. The connectors are soldered to and in electrical communication with an electrical conductor for transferring electrical energy to the conductor. More specifically, the conductors, which generally include sintered silver, are bonded to a substrate that is formed from glass, such as a backlite, sidelite, or windshield of a vehicle. The conductors are commonly visible on window panes of vehicles and typically extend horizontally across the window panes. The conductors are generally defoggers, defrosters, and antennas.

Traditionally, the connectors are soldered to the electrical conductors with a lead-based solder because lead is a deformable metal and minimizes mechanical stress between the connector and the substrate due to difference of thermal expansion of the connector and the substrate resulting from changes in temperature. More specifically, differences in coefficients of thermal expansion between the connectors, which are typically made of a good conductive material such as copper, and the substrates cause the mechanical stress. Such stress may result in cracking or other damage to the substrate, which is typically made of glass. Furthermore, the lead decreases the radical reaction rate between the tin in the solder and the silver in the conductor, allowing for good solderability. However, it is known that lead may be considered an environmental contaminant. As such, there is a motivation in many industries, including the automotive industry, to move away from all uses of lead in vehicles.

Conventional solder materials have been proposed that replace the lead in the solder with additional tin, along with small amounts of silver, copper, indium and bismuth. However, such materials have increased radical reaction rates between the tin-rich solder and the silver conductor, resulting in poor solderability. These conventional materials do not absorb the mechanical stress between the connector and the substrate due to thermal expansion of the connector and the substrate resulting from changes in temperature, which tends to crack or otherwise damage the substrate. Further, many alternative materials for the connector are difficult to solder, making it difficult to sufficiently adhere the connector to the conductor on the substrate. As a result, other techniques would be required in order to sufficiently adhere the alternative materials to the conductor on the substrate.

Although there has been development of various conductors for use in the window panes of vehicles, such developments have little applicability to electrical connector technology. For example, United States Patent No. 6,396,026 discloses a laminated pane for a vehicle including an electrical conductor disposed between two glass panes. The electrical conductor includes a layered structure that may include titanium to provide rigidity to the electrical conductor. The electrical conductor is positioned in an interlayer between the panes. In this position, the electrical conductor is spaced from the glass panes. The titanium-containing conductor in the '026 patent cannot effectively function as a connector that connects a power supply to a conductor that is bonded to one of the glass panes. More specifically, the titanium is disclosed as a core of the conductor, with an outer surface including a more conductive metal such as copper. The titanium core with the outer surface including copper is ineffective for use as an electrical connector due to the presence of the copper because the copper would delaminate from the conductor and/or cause the glass to crack due to mechanical stress between the copper and the glass pane due to thermal expansion of the copper and the glass pane resulting from changes in temperature.

Further, United States Patent Publication No. 2006/0056003 to Tonar et al. provides an electrical device that is typically used on a glass substrate. The electrical device includes a bus connection, i.e., an electrical connector, for supplying electrical power to an electro-optical element. The electrical connector is made from copper alloy or tin-plated copper, both of which are conventional materials that exhibit differences in coefficient of thermal expansion (with glass panes) that are too high. Although Tonar et al. provides that the electrical connector may utilize a metallic clip or strip that may be protected from the environment with metal plating or cladding, the metal plating or cladding performs no role in establishing a bond between the electrical connector and the glass substrate. Even more, many of the materials used for the metal plating or cladding are not of a type that would promote the establishment of a bond between the electrical connector and the connection site, and the difference in coefficients of thermal expansion between the electrical connector and the substrate eliminates any possibility of establishing the bond with a layer of solder.

U.S. Patent No. 2,644,066 to Glynn provides an electric heater, i.e., an electric conductor, that is disposed on a glass substrate. A metal disc, i.e., an electrical connector, made from a low expansion material is soldered onto the electric heater for supplying electrical power to the electric heater. In terminal areas of the electric heater, a coating of solderable metal is sprayed onto the electric heater because the electric heater is formed from a thin layer of aluminum that is difficult to solder due to its strong surface oxide layer. The electrical connector is connected to the layer of solderable metal through a layer of solder. However, the electrical connector of Glynn is in direct contact with the solder, which is undesirable, especially when the connector is made from materials that are difficult to solder. Further, the solder used in Glynn includes lead, and Glynn does not account for the difficulties that are encountered with traditional solders that do not include lead.

Thus, there remains a need to provide connectors that may be bonded to the conductor through a layer of solder, that may be soldered with solders that do not include lead, that can still reduce the mechanical stress between the connector and the substrate due to thermal expansion of the connector and the substrate resulting from changes in temperature, and that reduce the radical reaction rate to allow for good solderability.

The subject invention provides a window pane. The window pane includes a substrate. The subject invention also provides an electrical device for a window pane, and a vehicle including the window pane. The window pane includes an electrical conductor and an electrical connector. A layer of solderable metal is bonded to the electrical connector. A layer of solder is bonded to the layer of solderable metal and the conductor, with the connector and the conductor in electrical communication through the layer of solderable metal and the layer of solder.

The substrate has a first coefficient of thermal expansion and the connector has a second coefficient of thermal expansion. A difference between the first and second coefficients of thermal expansion is equal to or less than 5 x 10⁻⁶ /°C for minimizing mechanical stress between the connector and the substrate due to thermal expansion of the connector and the substrate resulting from changes in temperature. As a result, the connector resists delamination from the substrate.

The layer of solderable metal bonded to the connector provides a site to bond to the layer of solder. More specifically, due to the difference between the first and second coefficients of thermal expansion, the connector is typically formed from a material that is difficult to solder, and the layer of solderable metal eliminates any difficulty in bonding the connector to the conductor.

Other advantages of the present invention will be readily appreciated as the same becomes better understood by reference to the following detailed description when considered in connection with the accompanying drawings wherein:

Figure 1 is a perspective view of a vehicle including a rear window pane having an electrical device;

Figure 2 is a view of the window pane of Figure 1 with a power supply schematically illustrated;

Figure 2a is a partial view a portion of the window pane of Figure 2 including an electrical connector bonded to an electrical conductor;

Figure 3 is a schematic cross-sectional side view of the window pane taken along line 3-3 in Figure 2a illustrating the electrical conductor bonded to a ceramic layer, which is bonded to a substrate;

Figure 4 is a schematic cross-sectional side view of another embodiment of the window pane illustrating the electrical conductor bonded to the substrate absent the ceramic layer;

Figure 5 is a partial cross-sectional perspective view of yet another embodiment of the window pane including a cladding clad to the electrical connector; and

Figure 6 is a schematic cross-sectional side view of the window pane taken along line 6-6 of Figure 5.

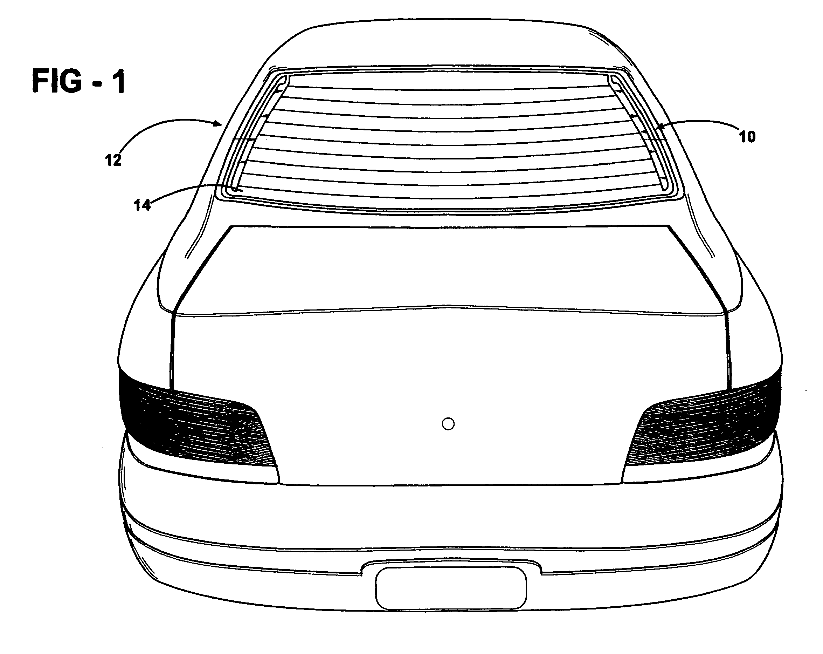

Referring to the Figures, wherein like numerals indicate like or corresponding parts throughout the several views, a window pane is generally shown at 10 on a vehicle **12** in Figure 1. The window pane **10** includes a substrate **14** that has a first coefficient of thermal expansion. The present invention also provides an electrical device **24** for a window pane **10** having a substrate **14,** with the electrical device **24** disposed on the substrate **14.** Further, the present invention provides the vehicle **12** including the window pane **10.**

Preferably, the substrate **14** is formed from glass; however, the substrate **14** may be formed from other materials such as ceramic. More preferably, the glass is further defined as an automotive glass. In a most preferred embodiment, the automotive glass is further defined as soda-lime-silica glass, which is well known for use in window panes **10** of vehicles **12.** However, it is to be appreciated that the glass may be any type of glass composition that is known in the art.

An electrical conductor **16** is applied across a region of the substrate **14.** Preferably, the conductor **16** includes silver; however, it is to be appreciated that other conductive metals may also be suitable for the conductor **16.** The electrical conductor **16** is visible on the pane **10** and typically includes lines **18** that extend horizontally across the pane **10.** The conductor **16** is preferably a defogger, defroster, antenna, or a combination thereof. However, the conductor **16** may serve any function known in the art for such conductors **16.**

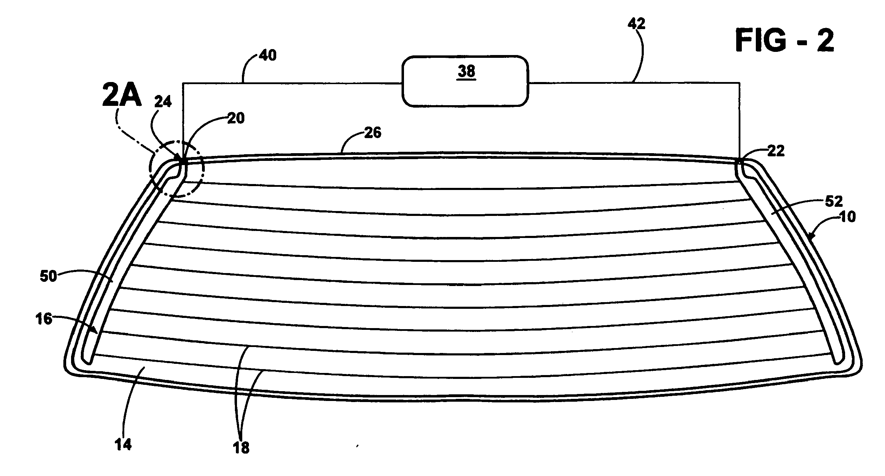

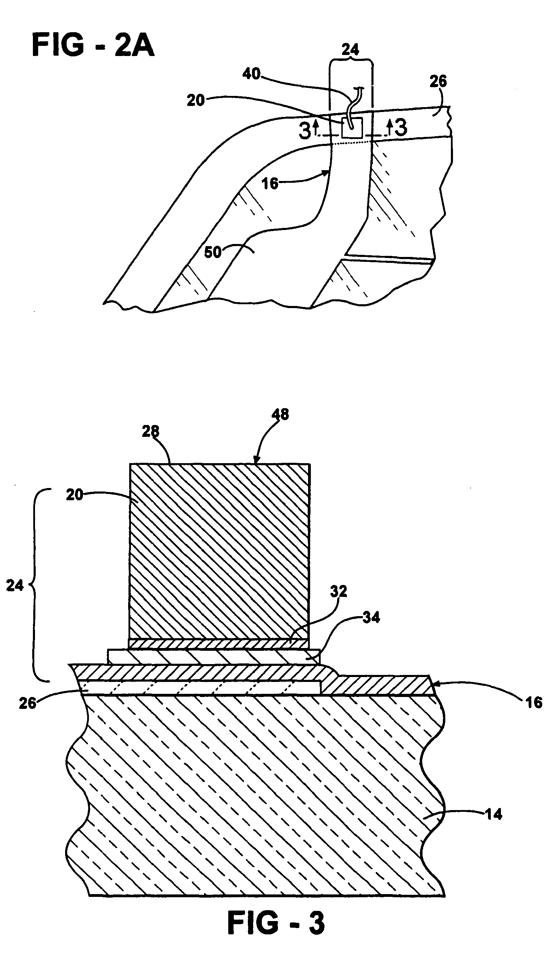

Referring to Figures 2 and 2a, the window pane **10** further includes an electrical connector **20.** As shown in Figure 3, a layer of solderable metal **32** is bonded to the connector **20.** A layer of solder **34** is bonded to the layer of solderable metal **32** and the conductor **16** with the connector **20** and the conductor **16** in electrical communication through the layer of solderable metal **32** and the layer of solder **34.** Together, the conductor **16,** the layer of solder **34,** the layer of solderable metal **32,** and the connector **20** form the electrical device **24.**

The electrical connector **20** has a second coefficient of thermal expansion. The connector **20** includes a metal having a low coefficient of thermal expansion (CTE). By "low coefficient of thermal expansion" it is meant that the metal has a sufficiently low CTE to make the difference between the first coefficient of thermal expansion of the substrate **14** and the second coefficient of thermal expansion of the connector **20** less than or equal to 5 x 10⁻⁶ /°C, more typically less than or equal to 4 x 10⁻⁶ /°C, most typically less than or equal to 3 x 10⁻⁶ /°C. Preferably, the connector **20** includes titanium; however other metals including, but not limited to, iron, molybdenum, tungsten, hafnium, tantalum, chromium, iridium, niobium, vanadium, platinum, and combinations thereof, as well as low CTE iron-nickel alloys, may be suitable tor the connector **20** so long as a difference between the first coefficient of thermal expansion of the substrate **14** and the second coefficient of thermal expansion of the connector **20** is less than or equal to 5 x 10⁻⁶ /°C, which will be described in further detail below. The titanium enables the connector **20** to reduce mechanical stress between the connector **20** and the substrate **14** due to thermal expansion of the connector **20** and the substrate **14** resulting from changes in temperature. More specifically, the mechanical stress is caused by differences between the first and second coefficients of expansion. The mechanical stress may cause cracking or other damage to the substrate **14,** and may also cause the connector **20** to separate from the substrate **14.**

Preferably, the titanium is present in the connector **20** in an amount of at least 50 parts by weight based on 100 parts by weight of the connector **20.** In a more preferred embodiment, the titanium is present in the connector **20** in an amount of at least 85 parts by weight, most preferably 99 parts by weight, based on 100 parts by weight of the connector **20.** A composition comprising 99 parts by weight of titanium based on 100 parts by weight of the composition is considered commercially pure titanium. In the most preferred embodiment, a remainder of the connector **20** may include iron, oxygen, carbon, nitrogen, and/or hydrogen, each of which may be present in an amount of less than or equal to 0.2 parts by weight based on 100 parts by weight of the connector **20.** Other residual elements may also be present in the connector **20** in an amount of less than 0.4 parts by weight based on 100 parts by weight of the connector **20.**

In another embodiment, the titanium may be an alloyed titanium that is alloyed with a metal selected from the group of aluminum, tin, copper, molybdenum, cobalt, nickel, zirconium, vanadium, chromium, niobium, tantalum, palladium, ruthenium, and combinations thereof. In this other embodiment, the metal is preferably present in the connector **20** in a total amount of from 0.05 to 50 parts by weight, more preferably from 1 to 10 parts by weight, most preferably from 1 to 5 parts by weight, based on 100 parts by weight of the connector **20.**

The titanium, as well as the solder composition that is typically free of lead (to be described in further detail below), is environmentally-friendly, and minimizes harmful effects to the environment to a greater extent than many other materials that are commonly used in connectors and solder compositions. Thus, waste tracking and disposal of excess titanium and solder composition from the manufacturing process and the processing of broken panes **10** is less stringent than for more environmentally harmful materials.

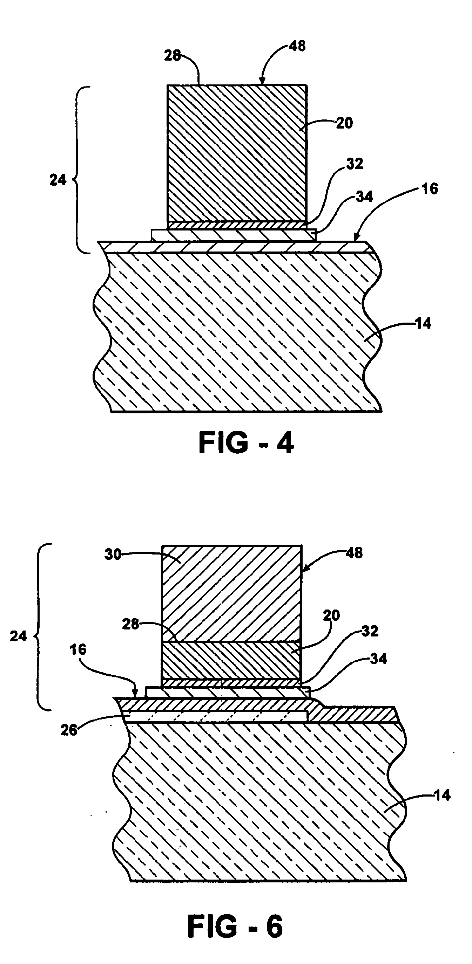

Besides environmental considerations, another advantage of the presence of titanium in the connector **20** is that the titanium has a substantially similar coefficient of thermal expansion to the substrate **14,** as briefly discussed above. Referring to Figure **4****,** although the connector **20** and the substrate **14** are not directly connected, i.e., the conductor **16,** the layer of solderable metal **32,** and the layer of solder **34** are disposed between the substrate **14** and the connector **20,** the substrate **14,** which has the first coefficient of thermal expansion, is rigid and prone to cracking when subjected to mechanical stress resulting from expansion and contraction of the connector **20** due to changes in temperature. Preferably, the conductor **16** has a relatively small thickness from 4 x 10⁻⁶ to 20 x 10⁻⁶ m, as compared to the connector **20,** which typically has a thickness from 0.2 x 10⁻³ to 2 x 10⁻³ m. As a result of the small thickness and silver content of the conductor **16,** the conductor **16** is malleable or deformable and deforms when subjected to mechanical stress resulting from expansion and contraction due to changes in temperature. Thus, the conductor **16** absorbs much of the mechanical stress due to changes in temperature. However, the connector **20** also expands and contracts due to the changes in temperature, which also results in mechanical stress that is absorbed by the conductor **16.** As a result, substantial differences between the first and second coefficients of thermal expansion result in excessive mechanical stress on the conductor **16** and the substrate **14.** The substrate **14** is generally more brittle than both the connector **20** and the conductor **16** and cracks due to the mechanical stress.

As set forth above, a difference between the first and second coefficients of thermal expansion is equal to or less than 5 x 10⁻⁶ /°C., taken as an average over the temperature range of from 0 to 300°C, which is sufficient to avoid cracking of the substrate **14** up to and including a temperature of 600°C. Preferably, the first coefficient of thermal expansion is from 8 to 9 x 10⁻⁶ /°C. As mentioned above, the substrate is preferably soda-lime-silica glass, which has a coefficient of thermal expansion of from 8.3 to 9 x 10⁻⁶ /°C, most preferably about 8.3 x 10⁻⁶ /°C, also taken as an average over a temperature range of from 0 to 300°C. Preferably, the second coefficient of thermal expansion is from 3 to 13 x 10⁻⁶ /°C, most preferably about 8.8 x 10⁻⁶ /°C, taken as an average over the temperature range of from 0 to 300°C.

As set forth above, the layer of solderable metal **32** is bonded to the connector **20.** More specifically, the bond between the layer of solderable metal **32** and the connector **20** is typically a mechanical bond and may be established by any known process including, but not limited to, cladding, sputtering, electroplating, or vacuum plating solderable metal onto the connector **20.**

The layer of solderable metal **32** may include any type of solderable metal that is capable of bonding to the connector **20** to establish the bond between the layer of solderable metal **32** and the connector **20,** and that further provides a binding site that exhibits excellent adhesion to the layer of solder **34.** Preferably, the solderable metal is capable of bonding to titanium. Typically, the solderable metal is selected from the group of copper, zinc, tin, silver, gold, and combinations thereof.

As set forth above, the layer of solder **34** is bonded to the layer of solderable metal **32** and the conductor **16.** Typically, the layer of solder 34 is bonded to the layer of solderable metal 32 and the conductor 16 by soldering.

The layer of solder **34** is formed from a solder composition. The solder composition typically includes tin and a reaction rate modifier, and is typically free of lead. The reaction rate modifier in the solder composition improves bonding between the conductor **16** and the layer of solderable metal **32,** as opposed to solder compositions that do not include the reaction rate modifier, and also serves the purpose of replacing at least a portion of the tin in the solder composition. Tin generates a compound with silver, such as the silver that may be in the conductor **16,** that helps form a strong bond between the layer of solder **34** and the conductor **16.** If solder does not include a certain amount of lead, this reaction is too radical and silver at the surface of the conductor **16** dissolves into the solder immediately, resulting in poor solderability and delamination between the layer of solder **34** and the conductor **16.** By including the reaction rate modifier in the solder composition instead of lead, the radical reaction may be suppressed and solderability improved in a way that is similar to when lead is included in the solder composition. The reaction rate modifier is typically a low-melting point metal, and may be selected from the group of, but is not limited to, bismuth, indium, zinc, and combinations thereof.

The reaction rate modifier is typically present in the solder composition in an amount of from 30 to 90 parts by weight based on 100 parts by weight of the solder composition. Most preferably, the reaction rate modifier is present in the solder composition in an amount of from 40 to 60 parts by weight, based on 100 parts by weight of the solder composition. The tin is typically included in the solder composition in an amount of from 10 to 70 parts by weight, most preferably from 25 to 50 parts by weight, based on 100 parts by weight of the solder composition. In addition to the tin and reaction rate modifier, the solder composition may also include other metals including, but not limited to, silver, copper, and combinations thereof for providing durability to the solder composition. When present, the silver may be included in an amount of equal to or less than 5 parts by weight based on 100 parts by weight of the solder composition. The copper may be included in an amount of equal to or less than 5 parts by weight based on 100 parts by weight of the solder composition, independent of the amount of silver included in the solder composition.

The layer of solderable metal **32** and the layer of solder **34** typically have a combined thickness that is sufficiently small to eliminate any effect of differences in coefficient of thermal expansion between the layer of solderable metal **32,** the layer of solder **34,** the connector **20,** and the substrate **14.** More specifically, the layer of solderable metal **32** and the layer of solder **34** typically have a combined thickness of less than or equal to 3.0 x 10⁻⁴ m, based on experimental results, which is sufficiently small to make the coefficient of thermal expansion of both the layer of solderable metal **32** and the layer of solder **34** immaterial, especially when the connector **20** has a thickness as great as 2 x 10⁻³ m. Due to the combined thickness of the layer of solderable metal **32** and the layer of solder **34** of less than or equal to 3.0 x 10⁻⁴ m, and the position of the layer of solderable metal **32** and the layer of solder **34** between two relatively stiff materials, i.e., the connector **20** and the substrate **14,** the layer of solderable metal **32** and the layer of solder **34** will deform during heating and cooling instead of transmitting thermal expansion mismatch stress to the substrate **14.**

It is to be appreciated that the electrical device **24** of the present invention includes the connector **20,** the layer of solderable metal **32,** the layer of solder **34,** and the conductor **16,** to the exclusion of the substrate **14.** More specifically, the electrical device **24** exists separate from the substrate **14,** and the electrical device **24** need not necessarily be incorporated in conjunction with the window pane **10.**

Besides silver, the conductor **16** may also include other materials such as glass frit and flow modifiers. The conductor **16** is applied to the substrate **14** as a paste, which is subsequently fired onto the substrate **14** through a sintering process. More specifically, after the paste is applied to the substrate **14,** the substrate **14** is subjected to a low temperature bake at about 200°C, which causes the flow modifiers to flash out of the paste. The substrate **14** is then subjected to sintering at about 650°C, which fires the paste onto the substrate **14** to form the conductor **16.** The sintering process also prevents mechanical stress from developing between the conductor **16** and the substrate **14.**

When the conductor **16** is a defroster or defogger, the conductor **16** may further include vertical strips **50, 52,** in addition to the lines **18,** disposed on opposite ends of the lines **18.** The strips **50, 52** electrically connect the lines **18.** The strips **50, 52,** in combination with the lines **18,** form a parallel circuit.

Referring to Figures 2 and 3, the pane **10** may include a ceramic layer **26** disposed adjacent to a periphery of the pane **10.** The ceramic layer **26** protects an adhesive on the substrate **14** from UV degradation. As known in the art, such adhesive is typically utilized to adhere the pane **10** to a body of the vehicle **12.** Thus, as shown in Figure 3, the ceramic layer **26** may be disposed between the substrate **14** and the conductor **16.** The ceramic layer **26** is generally black in color and has a negligible effect on the thermal expansion dynamics between the substrate **14,** the conductor **16,** and the connector **20.** Thus, in terms of thermal expansion dynamics, there is no significant difference between the configuration as shown in Figure 3, wherein the connector **20** is bonded to the conductor **16** on top of the ceramic layer **26,** and the configuration as shown in Figure 4, wherein the connector **20** is bonded to the conductor **16** on top of the substrate **14.**

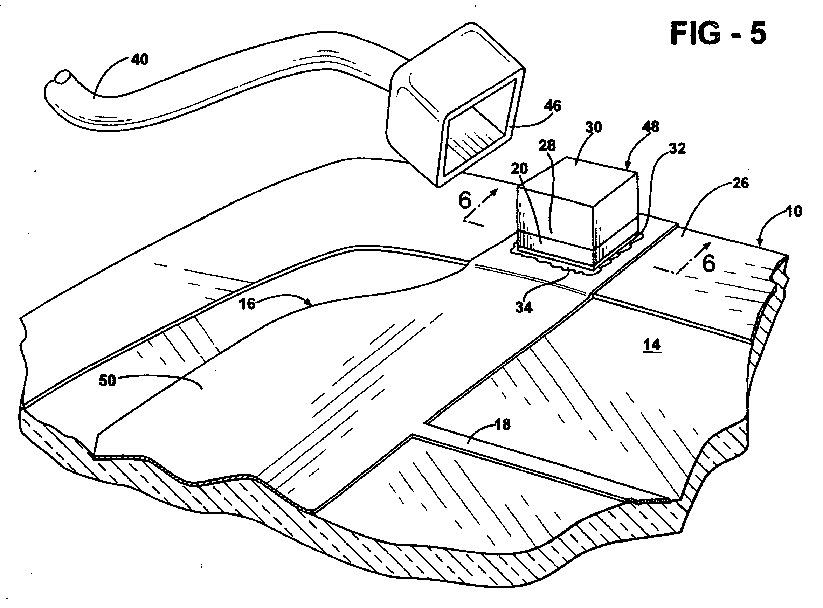

In one embodiment, shown in Figures 5 and 6, the connector **20** has an outer surface area **28** and a cladding **30** clad to the outer surface area **28.** It is to be appreciated that "cladding" refers to a layer of metal bonded to a metal substrate, in this case the connector **20,** and is not in any way limited to a method by which the cladding **30** is formed on the connector **20.** Preferably, the cladding **30** includes a metal selected from the group of copper, silver, aluminum, gold, and combinations thereof. The cladding **30** is more electrically conductive than the titanium to improve flow of electricity through the connector **20.** The cladding **30** is spaced from the conductor **16** such that the cladding **30** is mechanically insulated from the conductor **16** to avoid undue mechanical stress on the substrate **14** as discussed above, since the cladding **30** has a substantially different coefficient of thermal expansion from the substrate **14.**

Preferably, the cladding **30** and the connector **20** are present relative to one another in a volumetric ratio of from 0.01:1 to 4:1 such that the connector **20** includes enough titanium to sufficiently minimize the mechanical stress caused by expansion and contraction of the cladding **30** due to the changes in temperature.

In another embodiment, the connector **20** may comprise the alloyed titanium that has 50 parts by weight or less of copper based on 100 parts by weight of the connector **20,** with the balance comprising titanium, to eliminate the need for the cladding **30.**

The connector **20** transfers electrical energy to the conductor **16.** Typically, the connector **20** is connected to the conductor **16,** through the layer of solderable metal **32** and the layer of solder **34,** adjacent the periphery of the pane **10** on one side of the pane **10.** Preferably, a second connector **22** is bonded to and in electrical communication with the conductor **16,** also through a layer of solderable metal **32** and a layer of solder **34,** on an opposite side of the pane **10** from the connector **20.** However, it is to be appreciated that the second connector **22** is optional. The second connector **22** may transfer electrical energy away from the conductor **16.** In one embodiment, as shown schematically in Figure 2, the vehicle **12** includes the power supply **38** for providing the electrical energy. The power supply **38** may be a battery, alternator, etc. Preferably, both the connector **20** and the second connector **22** are operatively connected to and in electrical communication with the power supply **38.** The connector **20** transfers electrical energy from the power supply **38** to the conductor **16,** through the layer of solderable metal **32** and the layer of solder **34,** and the second connector **22** transfers electrical energy from the conductor **16** to the power supply **38.** More specifically, a lead wire **40** is operatively connected to and extends from the power supply **38** adjacent to the substrate **14.** The lead wire **40** is also operatively connected to the connector **20.** Another wire **42** extends from the power supply **38** to the second connector **22** and is operatively connected to the second connector **22** to complete an electrical circuit. The lead wire **40** and the wire **42** preferably include copper.

The operative connection between the lead wire **40** and the connector **20** may be formed through welding, a mechanical connection, etc. In one embodiment, a female member **46** extends from one of the connector **20** and the lead wire **40.** A male member **48** extends from the other of the connector **20** and the lead wire **40** for operatively connecting to the female member **46.** That is, as shown in Figure 5, the female member **46** can extend from the lead wire **40** when the male member **48** extends from the connector **20,** and vice versa. The operative connection between the second connector **22** and the second lead wire **42** may be the same as the operative connection between the connector **20** and the lead wire **40.** In a most preferred embodiment, shown in Figure 5, the lead wire **40** includes the female member **46** and the connector **20** includes the male member **48.** The female member **46** engages the male member **48** through compression to prevent separation between the lead wire **40** and the connector **20.** However, it is to be appreciated that the members **46, 48** may be connected through welding or other processes.

### EXAMPLES

Test plaques were made including the glass substrate **14,** the electrical conductor **16,** the electrical connector **20** including the layer of solderable metal **32,** and the layer of solder **34.** Half of the test plaques include glass substrates **14** with a ceramic layer **26,** and the electrical conductor **16** was bonded to the glass substrate **14** over the ceramic layer **26.** However, the results were the same for both configurations. The electrical conductor **16** was formed from silver paste for all of the plaques, and the silver paste was fired onto the substrate **14** to form the electrical conductor **16.** The layer of solderable metal **32** was formed on the connector **20** by sputtering. The connector **20** was soldered to the conductor **16** through the layer of solder **34.** The electrical connector **20,** the layer of solderable metal **32,** and the layer of solder **34** were formed from metals as indicated in Table 1. The glass substrate **14** was formed from soda-lime-silica

Further, the connectors soldered to the plaques were subjected to a pull test at least 24 hours after soldering. Referring to Table 1, the type and amount of metal used for the connector **20,** the layer of solderable metal **32,** and the layer of solder **34** are shown for each of the plaques, with amounts in parts by weight based on 100 parts by weight of the connector **20,** the layer of solderable metal **32,** or the layer of solder **34,** respectively, along with an indication of whether or not the plaque exhibits sufficient performance when subjected to changes in temperature. Furthermore, the properties of the soda-lime-silica glass are also included in the Table 1.

**TABLE 1**

| | **Material** | **Ex. A** | **Ex. B** |
|---|---|---|---|
| Electrical Connector | | | |
| | Titanium | 100.00 | 100.00 |
| | Avg. CTE, x 10⁻⁶ /°C over range of 0-100°C | 8.80 | 8.80 |
| | Difference between CTE of Connector and Glass Substrate, x 10⁻⁶ /°C over a range of 0-100°C | 0.5 | 0.5 |
| | Thickness of Electrical Connector, m | 8.0 x 10⁻⁴ | 8.0 x 10⁻⁴ |

| Layer of Solderable metal | | | |
|---|---|---|---|
| | Copper | 100.00 | 100.00 |
| | Thickness of Layer of Solderable Metal, m | 5.0 x 10⁻⁶ | 5.0 x 10⁻⁶ |

| Layer of solder | | | |
|---|---|---|---|
| | Tin | 48 | 30 |
| | Bismuth | 46 | 64 |
| | Silver | 2 | 2 |
| | Copper | 4 | 4 |
| | Thickness of Layer of Solder, m | 50-200 x 10⁻⁶ | 50-200 x 10⁻⁶ |
| | Combined Thickness of Layer of Solderable Metal and Layer of Solder, m | 55-205 x 10⁻⁶ | 55-205 x 10⁻⁶ |

| Glass Substrate | | | |
|---|---|---|---|
| (Soda-Lime-Silica) | | | |
| | Avg CTE, x 10⁻⁶ /°C over range of 0- 302°C | 8.3 | 8.3 |
| | Results of Pull Test | Good Pull Strength | Good Pull Strength |

### COMPARATIVE EXAMPLES

Comparative Examples of plaques are made for comparison to the plaques made in accordance with the present invention. More specifically, plaques for Comparative Examples A thru D were made the same as set forth above in the Examples, except for the amount of reaction rate modifier used and the thickness of the layer of solderable metal. In Comparative Example B, no layer of solderable metal is present. Referring to Table 2, the type and amount of metal used for the connector and the layer of solder are shown for each of the plaques, with amounts in parts by weight based on 100 parts by weight of the connector or the layer of solder, respectively, along with an indication of whether or not the plaque exhibits sufficient performance when subjected to changes in temperature. Furthermore, the properties of the soda-lime-silica glass are also included in the Table 2.

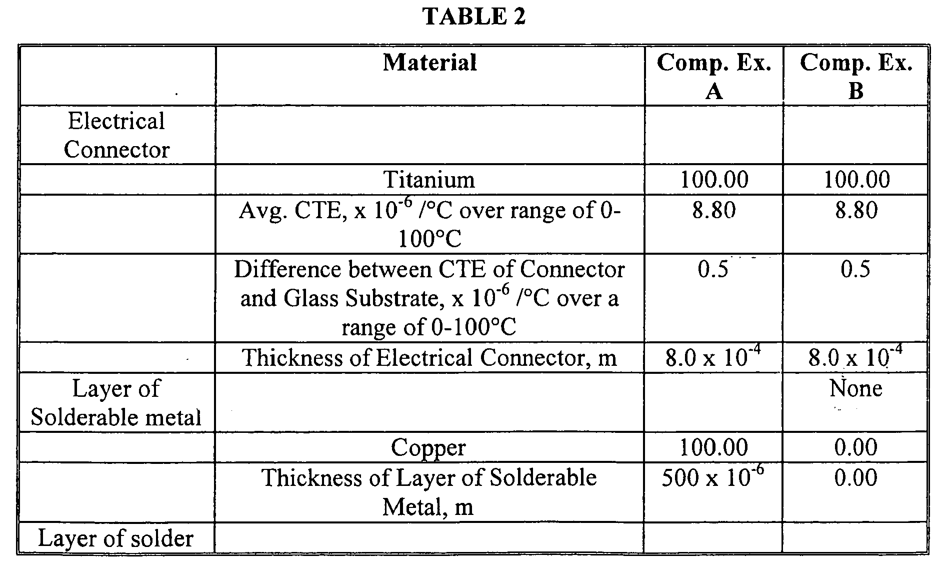

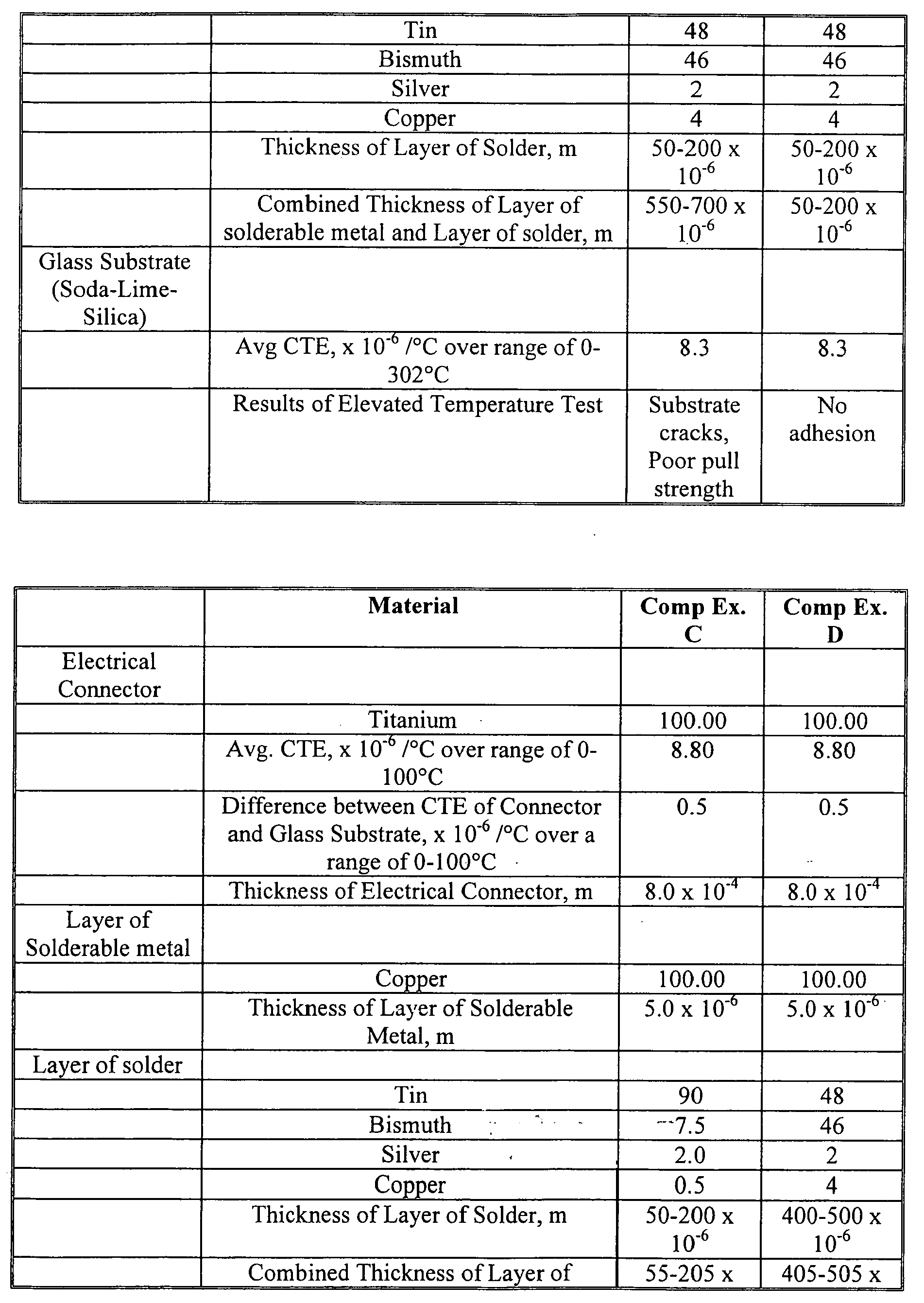

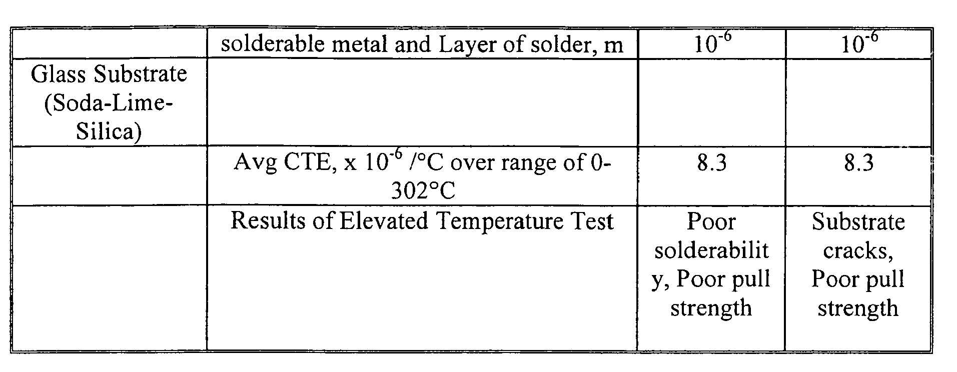

Obviously, many modifications and variations of the present invention are possible in light of the above teachings. It is, therefore, to be understood that within the scope of the appended claims, the invention may be practiced otherwise than as specifically described.

## Claims

1. A window pane comprising:
a substrate formed from glass and having a first coefficient of thermal expansion;
an electrical conductor applied across a region of said substrate;
an electrical connector having a second coefficient of thermal expansion with a difference between said first and second coefficients of thermal expansion equal to or less than 5 x 10⁻⁶ /°C;
a layer of solderable metal bonded to said connector; and
a layer of solder bonded to said layer of solderable metal and said conductor with said connector and said conductor in electrical communication through said layer of solderable metal and said layer of solder.

2. A window pane as claimed in claim 1 wherein said layer of solderable metal and said layer of solder have a combined thickness of less than or equal to 3.0 x 10⁻⁴ m.

3. A window pane as claimed in claim 1 or 2 wherein said bond between said layer of solder and said layer of solderable metal and between said layer of solder and said conductor is further defined as a metallic bond.

4. A window pane as claimed in claim 1 wherein said layer of solderable metal comprises a solderable metal selected from the group consisting of copper, zinc, tin, silver, gold and combinations thereof.

5. A window pane as claimed in claim 1 wherein said layer of solder is formed from a solder composition.

6. A window pane as claimed in claim 5 wherein said solder composition comprises a reaction rate modifier.

7. A window pane as claimed in claim 6 wherein said reaction rate modifier is selected from the group of bismuth, indium, zinc, and combinations thereof.

8. A window pane as claimed in claim 6 or 7 wherein said reaction rate modifier is present in said solder composition in an amount of from about 30 to about 90 parts by weight based on 100 parts by weight of said solder composition.

9. A window pane as claimed in claim 6 wherein said solder composition further comprises tin.

10. A window pane as claimed in claim 9 wherein said tin is present in said solder composition in an amount of from about 10 to about 70 parts by weight based on 100 parts by weight of said solder composition.

11. A window pane as claimed in claim 5 wherein said solder composition is free of lead.

12. A window pane as claimed in any preceding claim wherein said second coefficient of thermal expansion is from 3 to 13 x 10⁻⁶ /°C.

13. A window pane as claimed in any preceding claim wherein said first coefficient of thermal expansion is from 8 to 9 x 10⁻⁶ /°C.

14. A window pane as claimed in any preceding claim wherein said connector comprises at least one of titanium, molybdenum, tungsten, hafnium, tantalum, chromium, iridium, niobium, platinum, and vanadium.

15. A window pane as claimed in claim 1 wherein said connector comprises titanium.

16. A window pane as claimed in claim 15 wherein said titanium is present in said connector in an amount of at least 50 parts by weight based on 100 parts by weight of said connector.

17. A window pane as claimed in claim 16 wherein said titanium is present in said connector in an amount of at least 85 parts by weight based on 100 parts by weight of said connector.

18. A window pane as claimed in claim 15 wherein said titanium is alloyed with a metal selected from the group of aluminum, tin, copper, molybdenum, cobalt, nickel, zirconium, vanadium, chromium, niobium, tantalum, palladium, ruthenium, and combinations thereof.

19. A window pane as claimed in claim 18 wherein said metal is present in an amount of from 0.05 to 50 parts by weight based on 100 parts by weight of said connector.

20. A window pane as claimed in claim 1 wherein said connector comprises an iron-nickel alloy.

21. A window pane as claimed in any preceding claim wherein said connector has an outer surface area and a cladding clad to said outer surface area and spaced from said conductor such that said cladding is mechanically insulated from said conductor.

22. A window pane as claimed in claim 21 wherein said cladding comprises a metal selected from the group of copper, silver, aluminum, gold, and combinations thereof.

23. A window pane as claimed in claim 1 wherein said conductor comprises silver.

24. A window pane as claimed in claim 1 further comprising a ceramic layer disposed between said substrate and said conductor.

25. A window pane as claimed in claim 1 wherein said glass is further defined as automotive glass.

26. A window pane as claimed in claim 25 wherein said glass is further defined as soda-lime-silica glass.

27. A window pane as claimed in claim 1 wherein said conductor is selected from the group of defoggers, defrosters, antennas and combinations thereof.
